# FASCICULE DE BREVET EUROPEEN

(11) **EP 2 954 758 B1**
(45) Date de publication et mention de la délivrance du brevet: **07.12.2016**
(21) Numéro de dépôt: 13704058.0
(22) Date de dépôt: 06.02.2013
(51) Int. Cl.: H05H 1/46, H01J 37/32

(54) **SOURCE DE PLASMA**
PLASMAQUELLE
PLASMA SOURCE

(43) Date de publication de la demande: 16.12.2015
(73) Titulaire: Arcelormittal Investigación y Desarrollo SL, 48910 Sestao, Bizkaia (ES)
(72) Inventeur: DUMINICA, Florin Daniel, B-4130 Esneux (BE); LECLERCQ, Vincent, B-4890 Thimister (BE); SILBERBERG, Eric, B-5340 Haltinne (Gesves) (BE); DANIEL, Alain, B-4280 Hannut (BE)
(74) Mandataire: Domenego, Bertrand
(86) Numéro de dépôt international: PCT/EP2013/052340
(87) Numéro de publication internationale: WO 2014/121831

(56) Documents cités:
- WO-A1-95/25420
- US-A1- 2004 082 187
- US-A1- 2005 194 910
- US-A1- 2006 284 562

## Description

La présente invention se rapporte à une source de plasma destinée au dépôt d'un revêtement sur un substrat. La présente invention se rapporte donc à une source de plasma destinée au dépôt d'un revêtement sur un substrat et apte à être reliée à une source d'énergie.

La principale application de l'invention est le dépôt chimique en phase vapeur assisté par plasma (PECVD pour *Plasma-Enhanced Chemical Vapor Deposition)* qui est utilisé pour déposer une couche mince d'un revêtement sur un substrat à partir d'un précurseur en phase gazeuse.

Le principe de ce dépôt est simple puisqu'il consiste à générer un plasma dans lequel les produits issus de la décomposition d'un gaz précurseur vont se déposer sur le substrat et former le dépôt.

Dans le cadre de cette application, un large panel de substrats et de revêtements peut être envisagé. Les substrats les plus souvent traités par PECVD sont les matériaux diélectriques comme certains polymères et le verre, les métaux conducteurs, et les semiconducteurs. Sur ces substrats peut être déposée une large variété de revêtements comme le carbone adamantin désigné par le terme générique Diamond-like Carbon (DLC), le dioxyde de silicium (SiO₂), d'étain (SnO₂), de zirconium (ZrO₂) ou encore de titane (TiO₂). Ces revêtements sont utilisés par exemple pour protéger le substrat en déposant sur sa surface un film résistant à l'abrasion ; pour induire un effet anti-reflet ou créer une couche anti-traces de doigts ; ou encore pour conférer au substrat des propriétés photo-catalytiques utilisées dans le cadre de la fabrication de surfaces auto-nettoyantes.

Par ailleurs, le taux d'ionisation généré par le procédé PECVD est relativement faible comparé à d'autres procédés de dépôt sous vide ce qui conduit à une faible augmentation de la température du substrat. Ce procédé est donc particulièrement bien adapté au traitement des surfaces sensibles à la chaleur comme l'acier galvanisé ou l'acier peint.

On connait du document WO2004/027825 une source de plasma destinée au dépôt d'un revêtement sur un substrat. Cette source de plasma comprend une électrode délimitant une cavité de décharge et permettant le positionnement du substrat à recouvrir en regard d'une ouverture. La section transversale de l'électrode comprend deux parois latérales situées de part et d'autre d'un fond. Un ensemble magnétique est situé en périphérie de l'électrode et comprend deux aimants latéraux disposés derrière les parois latérales et orientés de telle façon que leurs pôles qui se font face soient de même polarité ainsi qu'un support magnétique situé en périphérie de l'électrode et reliant les deux aimants. Les deux aimants latéraux génèrent des lignes de champ sortantes, c'est-à-dire des lignes de champ dirigées des aimants latéraux vers l'extérieur de la cavité de décharge en passant par l'ouverture et des lignes de champ internes, c'est-à-dire des lignes de champ dirigées des aimants latéraux vers l'intérieur de la cavité de décharge.

Lors du fonctionnement de la source, des électrons sont arrachés de la surface de l'électrode et se retrouvent piégés dans les lignes de champ magnétique. En fonction de l'endroit duquel l'électron est arraché, il se retrouve piégé soit dans les lignes de champ internes soit dans les lignes de champ sortantes. Les électrons piégés dans les lignes de champ sortantes sortent de la source par l'ouverture et génèrent, à l'extérieur de la source de plasma, un plasma dans lequel le gaz précurseur va se décomposer. Cependant cette source de plasma présente une ouverture de largeur inférieure à la largeur de la cavité de décharge, ce qui perturbe l'éjection des électrons et limite de ce fait la densité du plasma. La qualité du revêtement et la vitesse de dépôt du revêtement sur le substrat s'en trouvent altérées.

On connait aussi le document US2005/0194910 A1 divulguant une source plasma capacitive pour iPVD utilisant des champs magnétiques.

L'invention a pour but de pallier les inconvénients de l'état de la technique en procurant une source de plasma permettant de produire à puissance égale un plasma plus dense et uniforme, et permettant en conséquence d'obtenir des revêtements de meilleure qualité et produits plus rapidement.

Pour résoudre ce problème, la source de plasma telle que mentionnée au début comprend
a) Une électrode délimitant une cavité de décharge débouchant sur une ouverture en regard de laquelle ledit substrat peut être positionné, la section transversale de ladite électrode comprenant une première et une deuxième paroi latérale situées de part et d'autre d'un fond muni d'une partie centrale faisant saillie dans ladite cavité de décharge, ladite partie centrale comprenant une première et une deuxième paroi centrale et un sommet reliant les deux parois centrales,
b) un ensemble magnétique situé en périphérie de ladite électrode et comprenant un ensemble d'aimants reliés entre eux par un support magnétique, chacun desdits aimants comprenant un pôle exposé tourné vers la cavité de décharge et un pôle protégé orienté vers ledit support magnétique, ledit ensemble d'aimants comprenant :
   i. au moins un premier et un deuxième aimant latéral, ledit premier aimant latéral, respectivement deuxième aimant latéral, étant disposé derrière ladite première paroi latérale, respectivement deuxième paroi latérale, à proximité de ladite ouverture, lesdits deux aimants latéraux étant orientés de telle façon que leurs pôles exposés soient de même polarité,
   ii. au moins un premier et un deuxième aimant central, ledit premier aimant central, respectivement deuxième aimant central, étant disposé derrière ladite première paroi centrale, respectivement deuxième paroi centrale, lesdits deux aimants centraux étant orientés de telle façon que leur pôle exposé soit de polarité inverse à celle des pôles exposés des aimants latéraux,
   iii. au moins un aimant de tête, disposé derrière ledit sommet et orienté de telle façon que son pôle exposé soit de même polarité que celle des pôles exposés des aimants latéraux,
c) une enceinte électriquement isolante agencée de sorte à entourer l'électrode et les aimants sans boucher ladite ouverture.

Il est donc prévu suivant l'invention, d'ajouter aux aimants latéraux au moins deux aimants centraux et au moins un aimant de tête, disposés derrière les parois d'une partie centrale de l'électrode. Cet ensemble d'au moins trois aimants permet de modifier la configuration des lignes de champ magnétique et en particulier d'accroitre la densité des lignes de champ sortantes. Lors du fonctionnement de la source de plasma, cette densification a pour effet de piéger dans les lignes de champ un plus grand nombre d'électrons et d'ions à l'extérieur de la source de plasma et au voisinage du substrat à revêtir. Ainsi à puissance égale, on obtient un plasma plus dense et on accélère le dépôt du revêtement sur le substrat.

De plus, cet ensemble d'au moins trois aimants accroit la densité de lignes de champ internes. Lors du fonctionnement de la source de plasma, cette densification a pour effet de concentrer les électrons dans ces lignes de champ. Ce réservoir d'électrons contribue à la stabilité du plasma. Ainsi il est possible de travailler à une pression qualifiée de haute pression, à savoir jusqu'à quelques mbar, par exemple entre 0,001 et 1 mbar alors que dans l'état de la technique, la pression maintenue doit être inférieure à 0,05 mbar. Ceci est également un avantage non négligeable en ce qu'un vide moins important engendre des coûts de fonctionnement moindres et un bilan énergétique plus favorable puisque le voltage nécessaire pour générer le plasma est inférieur à 400 V.

La source de plasma selon l'invention peut également comprendre les caractéristiques optionnelles indiquées dans les revendications dépendantes, ces caractéristiques optionnelles pouvant être prises isolément ou en combinaison.

Avantageusement, l'ouverture de la source de plasma selon l'invention est de même largeur que la cavité de décharge.

Dans un mode de réalisation préférentiel, le support magnétique présente la forme d'un E dont la barre du milieu comporte une extrémité élargie de sorte que le pôle protégé de l'aimant de tête soit entièrement en contact avec le support magnétique.

De préférence, le support magnétique est formé d'une seule pièce.

Avantageusement, la source de plasma comprend un moyen de refroidissement des aimants et de l'électrode.

Dans une forme de réalisation préférentielle, le moyen de refroidissement comprend un espace ménagé entre l'électrode et l'ensemble magnétique et destiné à la circulation d'un fluide caloporteur.

Avantageusement, le moyen de refroidissement comprend un circuit de tubulures.

Plus particulièrement, la source de plasma comprend en outre un moyen d'injection destiné à injecter un gaz ionisable dans la cavité de décharge.

Dans une forme préférée de l'invention, le moyen d'injection est positionné au voisinage du fond.

D'autres formes de réalisations de la source de plasma selon l'invention sont mentionnées dans les revendications annexées.

La présente invention se rapporte également à un Equipement de dépôt sous vide comprenant une source de plasma selon la présente invention.

Avantageusement, l'équipement de dépôt comprend en outre une deuxième source de plasma selon l'invention, les deux sources de plasma étant destinées à un fonctionnement dual.

Dans une variante avantageuse, les axes de symétrie des deux sources de plasma forment un angle α compris entre 20 et 110°.

De préférence, dans l'équipement selon l'invention, les pôles qui se font face des aimants latéraux de la première source de plasma sont de polarité inverse à celle des pôles qui se font face des aimants latéraux de la deuxième source de plasma.

Avantageusement, l'équipement selon l'invention comprend en outre un injecteur de gaz précurseur.

D'autres formes de réalisation de l'équipement sont mentionnées dans les revendications annexées.

D'autres caractéristiques, détails et avantages de l'invention ressortiront de la description donnée ci-après, à titre non limitatif et en faisant référence aux dessins annexés:
La figure 1 est une vue écorchée en perspective d'une source de plasma selon l'invention.
La figure 2 est une vue en coupe schématique selon d'axe A-A de la source de plasma de la figure 1
La figure 3 représente une description schématique de la configuration des lignes de champ magnétique de la source de plasma illustrée à la figure 2, générées à l'intérieur et à l'extérieur de la source de plasma.
La figure 4 représente une vue en coupe schématique d'un équipement de dépôt sous vide comprenant une source de plasma selon l'invention.
La figure 5 est une vue en coupe schématique d'un équipement de dépôt sous vide comprenant deux sources de plasma selon l'invention et dans lequel la source d'énergie est une source de courant alternatif.
La Figure 6 montre les résultats d'analyse par spectroscopie par transformée de Fourier de dépôts de silice obtenus au moyen d'une source de plasma selon l'état de la technique.
La figure 7 montre les résultats d'analyse par spectroscopie par transformée de Fourier de dépôts de silice obtenus au moyen d'une source de plasma selon l'invention.

Sur les figures, les éléments identiques ou analogues portent les mêmes références.

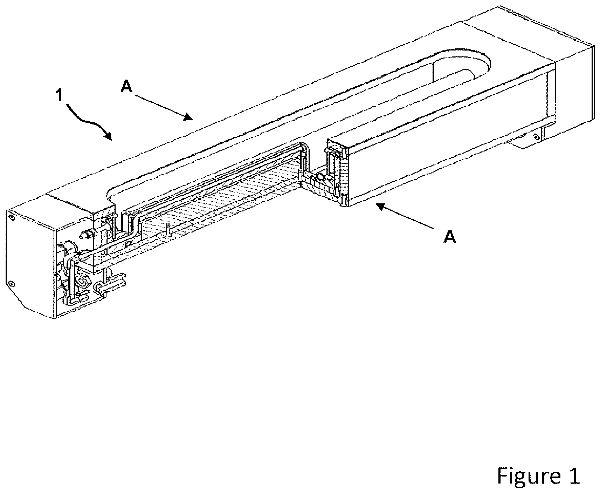

On décrit une source de plasma selon l'invention à l'appui des figures 1 à 3.

En référence à la figure 1, la source de plasma de ce mode de réalisation est de forme parallélépipédique allongée. Cette forme est recherchée dans le cas présent où la source de plasma est destinée au dépôt d'un revêtement sur une bande métallique de grande largeur en défilement. Afin d'obtenir une bonne uniformité de dépôt, il est préférable que la source de plasma soit plus longue que la largeur de bande métallique. Alternativement, et pour d'autres utilisations, la source de plasma pourra prendre d'autres formes, telles que par exemple celle d'un tore.

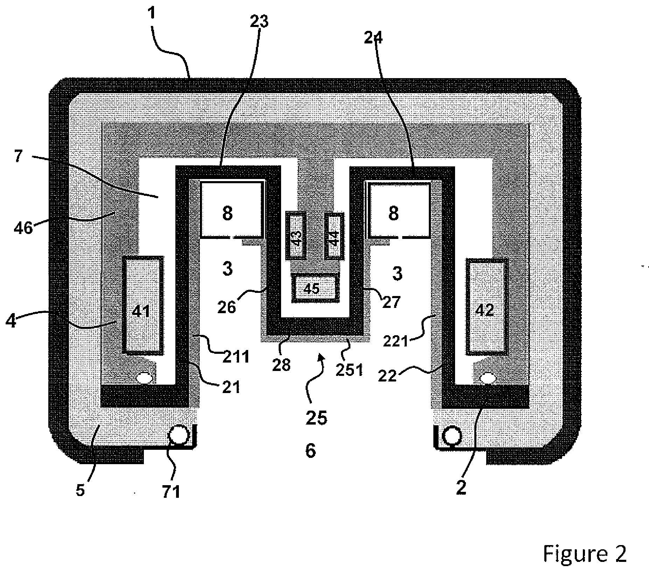

En référence à la figure 2, la source de plasma 1 comprend une électrode 2 dont la section transversale est approximativement en forme de E et qui délimite une cavité de décharge 3, un ensemble magnétique 4 situé en périphérie de l'électrode et une enceinte électriquement isolante 5 dont la section transversale est approximativement en forme de U de sorte à entourer l'électrode et l'ensemble magnétique tout en ménageant une ouverture 6 débouchant sur la cavité de décharge 3.

L'électrode 2 comprend tout d'abord une première paroi latérale 21 et une deuxième paroi latérale 22 correspondant aux barres inférieures et supérieures du E. Ces deux parois latérales constituent également les parois latérales de la cavité de décharge. La première paroi latérale 21, respectivement deuxième paroi latérale 22, est reliée par l'intermédiaire d'un fond 23, respectivement 24, à une partie centrale 25 correspondant à la barre intermédiaire du E.

La partie centrale 25 consiste en une saillie dans la cavité de décharge et est formée de deux parois centrales 26, 27 et d'un sommet 28 reliant les deux parois centrales.

L'ensemble de l'électrode est formé en un matériau conducteur non magnétique, tel que Cuivre, Al, Ti, inox 316, duquel seront arrachés les électrons lors du fonctionnement de la source de plasma. De préférence l'électrode est formée d'une seule pièce car cette pièce peut être utilisée comme paroi de refroidissement. Cependant, on pourra alternativement recourir à un ensemble de pièces assemblées entre elles de sorte à former l'électrode. De plus, pour limiter la dégradation de l'électrode soumise à du bombardement ionique, les électrodes peuvent être protégées par des plaques 211, 221 et 251 constituées de conducteurs métalliques non magnétiques comme l'aluminium, l'inox 316 et le Ti.

L'ensemble magnétique 4 comprend un ensemble d'aimants reliés entre eux au moyen d'un support magnétique et disposés de sorte à générer des lignes de champ magnétique sortantes particulièrement denses au voisinage de l'ouverture 6.

De préférence, les aimants sont permanents et choisis dans le groupe des aimants de type NdFeB ou SmCo.

L'ensemble magnétique 4 comprend, tout d'abord, un premier aimant latéral 41 disposé derrière la première paroi latérale de l'électrode à proximité de l'ouverture 6. Symétriquement, un deuxième aimant latéral 42 est disposé derrière la deuxième paroi latérale de l'électrode à proximité de l'ouverture 6.

Les aimants latéraux 41 et 42 comprennent chacun un pôle exposé orienté vers la cavité de décharge et un pôle protégé orienté vers l'enceinte isolante. Les deux aimants latéraux sont orientés de telle façon que leurs pôles exposés, qui se font face, soient de même polarité.

L'ensemble magnétique 4 comprend également un premier aimant central 43 disposé derrière la première paroi centrale 26 de l'électrode à proximité du fond 23. Symétriquement, un deuxième aimant central 44 est disposé derrière la deuxième paroi centrale 27 de l'électrode à proximité du fond 24.

Les aimants centraux 43 et 44 comprennent chacun un pôle exposé orienté vers la cavité de décharge et un pôle protégé orienté vers l'intérieur de la partie centrale. Les deux aimants latéraux sont orientés de telle façon que leurs pôles exposés soient de polarité inverse à celle des deux pôles exposés des aimants latéraux 41 et 42.

L'ensemble magnétique 4 comprend enfin un aimant de tête 45 situé derrière le sommet 28 de la partie centrale 25. Cet aimant comprend un pôle exposé orienté vers la cavité de décharge et un pôle protégé orienté vers l'intérieur de la partie centrale. Il est orienté de telle façon que son pôle exposé soit de même polarité que celle des pôles exposés des aimants latéraux 41 et 42.

Tous les aimants de l'ensemble magnétique sont reliés entre eux au moyen d'un support magnétique 46 situé en périphérie de l'électrode. Dans l'exemple de la figure 2, sa section transversale est approximativement en forme de E. Pour que l'électrode fonctionne, il suffit que chaque aimant soit en contact au moins en un point avec le support magnétique. Cependant, de façon à éviter les fuites magnétiques, on veillera de préférence à ce que le pôle protégé de chaque aimant soit intégralement en contact avec le support magnétique. A cet effet, le support magnétique donné en exemple à la figure 2 présente la forme d'un E dont la barre du milieu présente une extrémité élargie de sorte que la face protégée de l'aimant 45 soit entièrement en contact avec le support magnétique.

De préférence, et toujours dans un souci d'éviter les fuites magnétiques, le support magnétique est formé d'une seule pièce. Cependant, pour faciliter le montage, on pourra recourir à un ensemble de pièces assemblées entre elles de sorte à former un ensemble continu.

Le support magnétique 46 est formé de tout matériau présentant une perméabilité magnétique relative élevée, de préférence supérieure à 2000, tel que par exemple le mumétal®, les aciers permalloy® et les métaux Ni, Fe et Co.

Les orientations respectives des aimants peuvent se résumer au moyen des tableaux 1 et 2 suivants qui illustrent deux variantes :

**Tableau 1.-**

| Aimant | Polarité | |
|---|---|---|
| | Pôle exposé | Pôle protégé |
| Aimant latéral 41 | N | S |
| Aimant latéral 42 | N | S |
| Aimant central 43 | S | N |
| Aimant central 44 | S | N |
| Aimant de tête 45 | N | S |

**Tableau 2.-**

| Aimant | Polarité | |
|---|---|---|
| | Pôle exposé | Pôle protégé |
| Aimant latéral 41 | S | N |
| Aimant latéral 42 | S | N |
| Aimant central 43 | N | S |
| Aimant central 44 | N | S |
| Aimant de tête 45 | S | N |

Comme illustré à la figure 2, la disposition et l'orientation des aimants, telles que décrites ci-dessus, ont les effets suivants :
- les aimants latéraux 41 et 42 génèrent des lignes de champ sortantes, c'est-à-dire des lignes de champ dirigées des aimants latéraux vers l'extérieur de la cavité de décharge en passant par l'ouverture 6 et des lignes de champ internes, c'est-à-dire des lignes de champ dirigées des aimants latéraux vers l'intérieur de la cavité de décharge, et en particulier vers la partie centrale.
- L'aimant de tête 45 génère principalement des lignes de champ sortantes qui s'additionnent à celles produites par les aimants latéraux, augmentant ainsi sensiblement la densité de lignes de champ sortantes, améliorant ainsi l'efficacité de la source de plasma comme cela sera illustré ultérieurement.
- Les aimants centraux 43, 44 permettent tout d'abord que l'aimant de tête soit mis au contact du support magnétique. En effet, en leur absence, la partie centrale du support magnétique présente une polarité égale à celle de la face protégée des aimants latéraux, autrement dit une polarité identique à celle de la face protégée de l'aimant de tête, ce qui a pour effet de repousser l'aimant de tête que l'on veut mettre en place. Au contraire, en leur présence, la partie centrale du support magnétique présente une polarité inverse de celle de la face protégée des aimants latéraux car :
   ∘ Dans un premier temps, les aimants centraux 43, 44 qui présentent une polarité de la face protégée inverse de celle de la face protégée des aimants latéraux ont pu être fixés sur le support magnétique à la base de la partie centrale qui présentait alors une polarité égale à celle de la face protégée des aimants latéraux.
   ∘ Leur fixation a inversé la polarité de l'extrémité de la partie centrale du support magnétique, cette extrémité étant maintenant au contact de la face protégée des aimants centraux.
      - Les aimants centraux 43, 44 permettent, de plus, d'intensifier les lignes de champ internes grâce aux boucles magnétiques générées entre ces aimants et les aimants latéraux, via le support magnétique.

Autrement dit, l'ensemble des aimants induit :
a) une région 100 dense en lignes de champ externes, située principalement à l'extérieur de la source de plasma au voisinage de l'ouverture,
b) deux régions 101 où le champ magnétique résultant est nul, situées dans la cavité de décharge entre l'ouverture et le sommet de la partie centrale,
c) deux régions 102 présentant une forte densité de lignes de champ internes, situées de part et d'autre de la partie centrale.

Afin d'optimiser la configuration des lignes de champ magnétique, on ajustera de préférence la longueur des aimants latéraux et la distance entre l'aimant de tête et la médiatrice des aimants latéraux, de sorte que les aimants latéraux interagissent bien avec les aimants centraux et que l'aimant de tête interagisse de façon équilibré tant avec les aimants centraux qu'avec les aimants latéraux. De préférence l'aimant de tête sera placé de telle manière que son pôle exposé soit sur la médiatrice des aimants latéraux. De préférence l'aimant de tête est placé au centre de l'électrode. La distance entre les pôles exposés des aimants latéraux est de préférence comprise entre 8 à 12 centimètres.

La description ci-dessus correspondait à celle de la section transversale de la source de plasma. Cette dernière étant cependant allongée, il va de soi que chacun des aimants décrits ci-dessus peut consister en une succession d'aimants juxtaposés et alignés dans le sens longitudinal de la source de plasma et non simplement en un aimant unique.

Grâce à leur disposition derrière les parois latérales, les parois centrales et le sommet, les aimants sont isolés de l'environnement régnant dans la cavité de décharge lors du fonctionnement de la source de plasma et ne sont ainsi pas abimés. De plus, ils peuvent ainsi facilement être refroidis afin que leur température ne dépasse pas la température de Curie, température à laquelle ils perdent leurs propriétés magnétiques. En effet, le risque de démagnétisation des aimants est élevé lorsque ces derniers sont amenés à des températures telles que celles rencontrées dans la cavité de décharge lors d'une décharge magnétron.

Pour ce faire, la source de plasma contient de préférence un moyen de refroidissement 7 des aimants et de l'électrode. Comme illustré à la figure 2, le refroidissement peut être assuré par une circulation de fluide caloporteur dans un espace ménagé entre l'électrode et l'ensemble magnétique. Ce type de refroidissement a pour avantage de permettre d'isoler électriquement les aimants de l'électrode lorsqu'on fait circuler un fluide caloporteur isolant électrique tel que de l'eau déminéralisée.

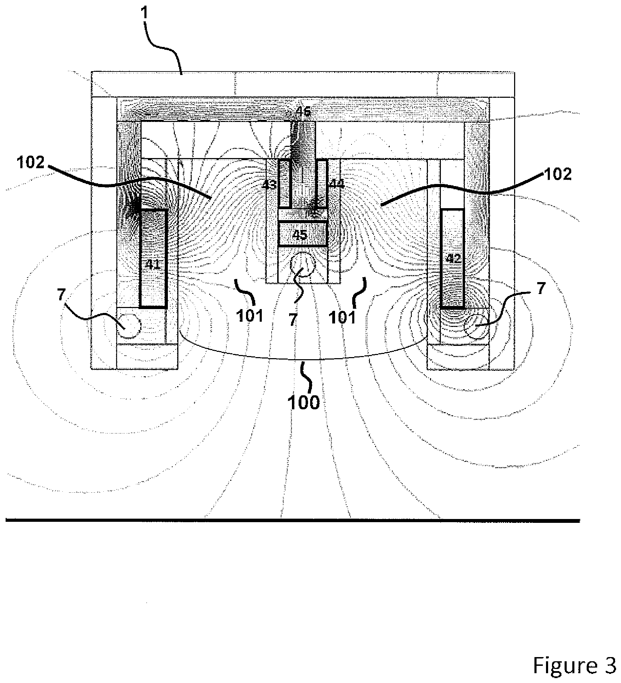

Alternativement, et comme illustré à la figure 3, le moyen de refroidissement 7 peut consister en un circuit de tubulures brasées traversant l'épaisseur de l'électrode ou disposées au contact de la périphérie de celle-ci. Lors du fonctionnement de la source de plasma, le refroidissement est assuré par une circulation, dans les tubulures, d'eau ou d'autres fluides caloporteurs.

La source de plasma 1 comprend enfin une enceinte isolante dont la section transversale est approximativement en forme de U de sorte à entourer l'électrode et les aimants tout en ménageant une ouverture 6. Comme on le verra ultérieurement lors de la description du fonctionnement du dispositif, il n'est pas nécessaire que l'ouverture 6 soit de largeur inférieure à la largeur de la cavité de décharge comme c'est le cas pour les dispositifs de l'état de la technique. De préférence, l'ouverture 6 est donc de même largeur que la cavité de décharge. Le recours à une enceinte isolante permet de garantir que les décharges électriques générées lors du fonctionnement de la source de plasma n'émaneront que de l'électrode 2.

L'enceinte isolante comprend un matériau électriquement isolant, de préférence, un matériau diélectrique choisi dans le groupe constitué des micanites, du téflon, des résines chargée en céramiques....

Lors du fonctionnement de l'électrode le bombardement électronique et ionique peut générer un échauffement des matières diélectriques de l'enceinte isolante 5, ce qui peut générer des contraintes mécaniques locales ; Pour pallier à cet inconvénient, des plaques refroidies à l'eau 71 peuvent être placées sur le diélectrique 5 de part et d'autre de l'ouverture 6, comme illustré à la figure 2.

De préférence, la source de plasma comprend également des moyens d'injection 8 permettant d'injecter un gaz ionisable dans la cavité de décharge. La forme et la position de ces moyens d'injection peuvent être variées. De préférence, on positionnera les moyens d'injection au voisinage du fond 23 et/ou du fond 24 de sorte que, lors du fonctionnement de la source de plasma, le gaz ionisable circule des fonds vers l'ouverture 6. Dans l'exemple de la figure 2, les moyens d'injection consistent en des tubulures d'injection placées devant les fonds 23 et 24 de l'électrode, dans la cavité de décharge. Il s'agit ici de tubes en acier inoxydable présentant des orifices pour une distribution uniforme du gaz sur la longueur du tube. Alternativement les moyens d'injection peuvent être partiellement intégrés dans les fonds. De préférence, un moyen d'injection est disposé au voisinage de chacun des fonds 23 et 24, de sorte que le gaz ionisable soit réparti de façon homogène dans la cavité de décharge. Le fonctionnement et les avantages de ce système d'injection seront décrits ultérieurement.

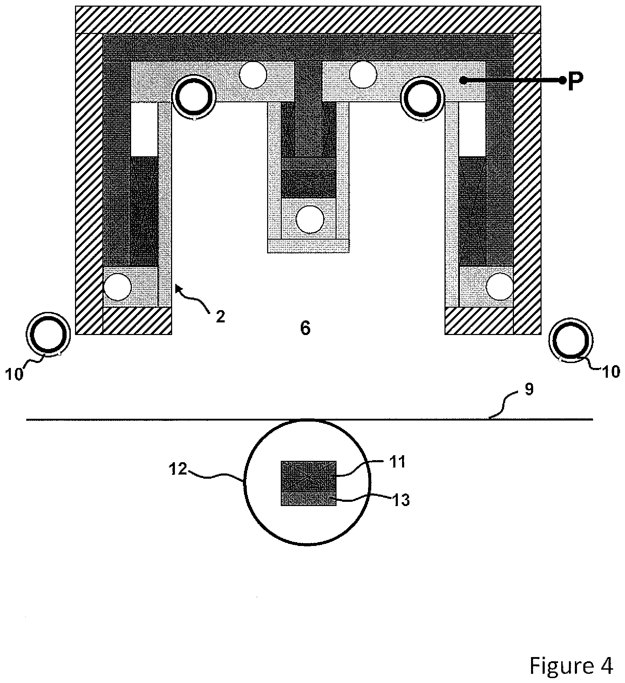

On décrit maintenant la source de plasma en fonctionnement, selon un premier mode, dans un équipement de dépôt sous vide, en référence à la figure 4.

Tout d'abord, la source de plasma est placée dans une chambre de traitement (non représentée) maintenue sous vide.et agencée pour accueillir un substrat 9, de préférence sous la forme d'une bande en défilement. La source de plasma est disposée de sorte que l'ouverture 6 soit en regard du substrat 9 et de préférence elle est disposée de manière sensiblement transversale par rapport au sens de défilement de la bande de substrat 9

L'électrode 2 de la source de plasma est reliée à une source d'énergie P, typiquement une source de courant continu ou alternatif, habituellement située hors de la chambre de traitement. Dans le cas de ce premier mode de fonctionnement, le rôle de contre-électrode est joué par le substrat 9 en défilement et mis à la terre.

La chambre de traitement comprend également au moins un injecteur 10 de gaz précurseur. Cet injecteur peut être fixé sur la source de plasma à proximité de l'ouverture 6. De préférence, il sera cependant indépendant de la source de plasma et situé à proximité des bords latéraux de la source de plasma de sorte à éviter l'injection de gaz précurseur en direction de la cavité de décharge, ce qui contribuerait à l'encrassement de celle-ci. Dans l'exemple de la figure 4, les injecteurs sont formés d'un réseau de tubes en acier inoxydable poreux présentant une forte perte de charge et entourées par des tubes présentant des orifices distribués de manière à assurer une distribution uniforme du gaz sur toute la longueur de la tubulure. Cependant tout type d'injecteur de gaz précurseur sous vide connu peut être utilisé ici.

Lorsque la source d'énergie P est activée, il se crée tout d'abord une différence de potentiel électrique entre l'électrode 2 et le substrat. Sous l'effet de cette différence de potentiel, des électrons sont arrachés de la surface de l'électrode et se retrouvent piégés dans les lignes de champ magnétique. En fonction de l'endroit duquel l'électron est arraché, il se retrouve piégé soit dans les lignes de champ internes soit dans les lignes de champ sortantes.

Grâce à la forte densité de lignes de champ sortantes obtenue grâce à la disposition particulière des aimants selon l'invention, un grand nombre d'électrons se retrouvent piégés dans les lignes de champ sortantes au voisinage de l'ouverture 6 et à proximité du substrat 9.

Le gaz précurseur, injecté en direction de l'espace compris entre la source de plasma et le substrat, s'ionise au contact de la forte densité électronique et forme ainsi un plasma.

Un gaz ionisable est injecté depuis le fond de la cavité de décharge via les moyens d'injection 8. La force d'injection pousse le gaz ionisable vers les régions 102 présentant une forte densité de lignes de champ internes, situées de part et d'autre de la partie centrale, où il s'ionise par collision avec les électrons piégés dans les lignes de champ internes.

Une partie de ces ions entre en collision avec les parois de l'électrode. Ceci contribue à éviter l'éventuel encrassement de la cavité de décharge par les produits issus de la décomposition du gaz précurseur et susceptibles de pénétrer dans la cavité de décharge. L'efficacité de ce nettoyage peut permettre de se passer d'une ouverture de largeur inférieure à la largeur de la cavité, ce qui contribue encore à faciliter la sortie des électrons de la source plasma et donc contribue à l'amélioration des performances de celle-ci.

De plus, les ions éjectés hors de la source de plasma bombardent le substrat, ce qui apporte de l'énergie à ce dernier et contribue ainsi à la densification de la couche déposée.

Enfin, le gaz ionisable pousse vers le substrat le gaz précurseur en limitant ainsi la formation d'un dépôt à l'intérieur de la source de plasma.

Optionnellement, le gaz ionisant peut être en même temps un gaz réactif qui peut réagir avec le gaz précurseur.

Pour résumer, la densification des lignes de champ sortantes a pour effet de davantage concentrer les électrons et les ions à l'extérieur de la source de plasma et au voisinage du substrat à revêtir. Ainsi à puissance égale, on obtient un plasma plus dense et on accélère le dépôt du revêtement sur le substrat.

Optionnellement, et comme on peut le voir à la figure 4, la chambre de traitement peut contenir un aimant additionnel 11 positionné en regard de l'ouverture 6, au voisinage du substrat du coté opposé à la source de plasma. Il peut par exemple être incorporé dans un rouleau de transport de bande 12. Son pôle exposé orienté vers la source de plasma 1 est de polarité inverse de celle des pôles exposés des aimants latéraux. Cet aimant additionnel permet de densifier les lignes de champ externes au voisinage du substrat et ainsi d'accélérer le dépôt du revêtement. Cependant, cette densification entrainant une augmentation de la température du substrat, on évitera de recourir à cet aimant additionnel lors du traitement de substrats sensibles à des températures de l'ordre de quelques centaines de degrés.

Dans le cas où l'aimant 11 serait constitué d'une succession d'aimants juxtaposés et alignés dans le sens longitudinal de la source de plasma, ceux-ci seront disposés sur un support magnétique 13 de façon à permettre leur juxtaposition.

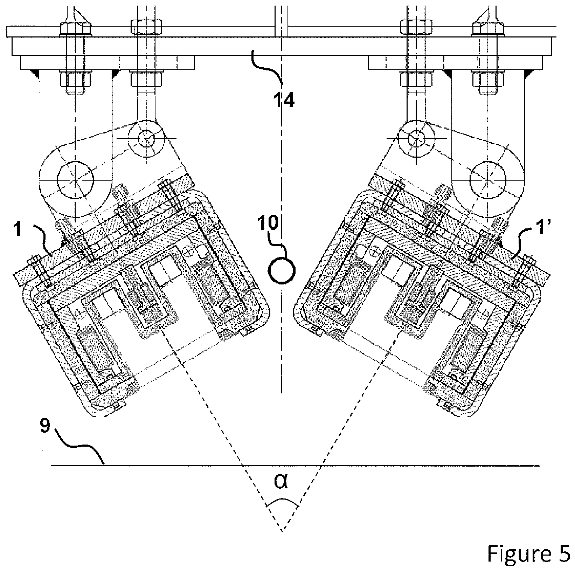

Comme la figure 5 le montre, la source de plasma peut fonctionner dans un équipement de dépôt sous vide selon un second mode. Dans ce cas, la chambre de traitement comprend une deuxième source de plasma qui joue le rôle de contre électrode.

La source d'énergie P est alors une source de courant alternatif. Pour augmenter la puissance électrique des électrodes de grande dimension, plusieurs sources d'énergie peuvent être synchronisées.

La source d'énergie P est reliée à l'électrode 2 de la première source de plasma 1 et à la contre-électrode 2' qui est l'électrode de la deuxième source de plasma 1', ces deux électrodes fonctionnant alternativement comme :
- source d'électrons, lorsque l'électrode joue le rôle de cathode,
- et source d'ions, lorsque l'électrode joue le rôle d'anode, le gaz ionisé par les électrons en provenance de la cathode, étant expulsé en direction de la cathode et du substrat.

On parle dans ce cas d'un fonctionnement dual.

De préférence, et comme illustré à la figure 5, les deux sources de plasma sont supportées de manière pivotante par un bras horizontal 14 de telle manière que les deux ouvertures 6 soit inclinées l'une vers l'autre d'un angle α formé par les axes de symétrie des sources de plasma. L'angle α est compris entre 20 et 110°, de préférence entre 40 et 90° et de manière plus préférentielle est d'environ 60°.

Une telle disposition de l'électrode et de la contre-électrode a l'avantage de concentrer les faisceaux d'électrons et le gaz précurseur dans un espace plus confiné. Ce confinement permet d'atteindre plus facilement l'énergie d'activation du précurseur, ce qui facilite le dépôt.

Les pôles qui se font face des aimants latéraux de l'électrode peuvent être de même polarité que les pôles qui se font face des aimants latéraux de la contre-électrode ou alternativement de polarité inverse. Dans ce dernier cas, la continuité des lignes de champ entre les deux électrodes facilite le dépôt.

Dans ce second mode de fonctionnement, le substrat 9, qu'il soit conducteur de courant ou isolant électrique, est électriquement isolé de la source de plasma. Dans le cas où un substrat conducteur de courant est traité, l'isolation électrique est assurée par une mise à la terre du substrat 9. Un avantage de ce mode de fonctionnement est de permettre le dépôt sur le substrat d'un revêtement diélectrique, ce qui est difficile à réaliser avec une source de courant continu. Pour un tel revêtement, une simple décharge en courant continu ne peut suffire car cette dernière s'éteindra rapidement. En effet, au cours du dépôt la surface du substrat se charge sous l'impact des ions. Si la surface est isolante, la charge excédentaire qui est induite par les impacts des ions ne peut s'écouler. Par conséquent le plasma s'éteint et le dépôt ne peut se poursuivre. Ceci explique que la pulvérisation en courant continu ne soit généralement utilisée que pour les dépôts de couches conductrices ou semiconductrices.

Les essais réalisés avec des sources de plasma selon l'invention ont permis de montrer que les aimants centraux et l'aimant de tête contribuaient significativement à la densification des lignes de champ et par conséquent amélioraient la vitesse et la qualité de dépôt.

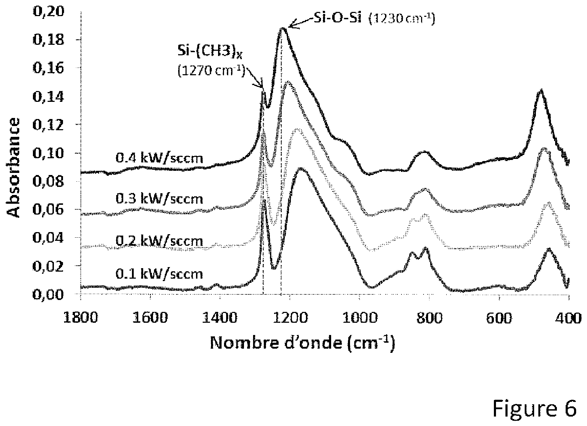

La figure 6 montre les résultats d'analyse par spectroscopie par transformée de Fourier de dépôts de silice obtenus au moyen d'une source de plasma selon l'état de la technique dont on a fait varier la puissance électrique (en kW) rapportée au débit de gaz précurseur (hexaméthyledisiloxane ou HMDSO), le débit étant exprimé en cm³ standard par seconde (sccm). Les dépôts ont été réalisés dans les conditions suivantes: gaz ionisable O₂, rapport O₂/HMDSO égal à 5, pression de 0,2 mbar, distance substrat-source de plasma égale à 50 mm. On peut constater que, pour un ratio O₂/HMDSO faible, les silices obtenues ont un caractère organique (présence de liaisons Si-(CH3) x - pic à 1270 cm⁻¹) et ce quelque soit la puissance appliquée. Ce caractère organique est indésirable car il altère la qualité du revêtement.

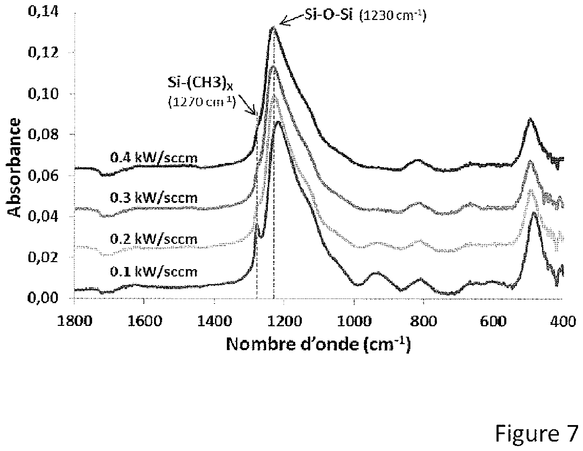

La figure 7 montre les résultats d'analyse par spectroscopie par transformée de Fourier de dépôts de silice obtenus au moyen d'une source de plasma selon l'invention. Les dépôts ont été réalisés dans les mêmes conditions que ceux de la figure 6. On peut constater que, pour des puissances supérieures à 0,2 kW/sccm, les dépôts de silice obtenus sont inorganiques (disparition du pic à 1270 cm⁻¹) et donc de bien meilleure qualité.

Ces résultats illustrent également que la source de plasma selon l'invention permet d'obtenir des silices inorganiques pour des débits d'oxygène moindres et des pressions supérieures à celles de l'état de la technique. Ceci a pour avantage de minimiser le débit de pompage dans la chambre de traitement et donc de minimiser le nombre de pompes nécessaires.

La configuration de la source de plasma décrite permet également, par rapport à l'état de la technique, d'augmenter le taux de dépôt pour atteindre des rendements de dépôts supérieurs. Le rendement de dépôt peut atteindre 80 %, nettement supérieur à l'état de la technique pour lequel le rendement est de l'ordre de 40-50 %. Le rendement de dépôt est défini, dans le cas d'un dépôt de silice, comme étant la proportion d'atomes de Silicium du HMDSO qui se retrouve dans la couche de silice formée.

Il est bien entendu que la présente invention n'est en aucune façon limitée aux formes de réalisations décrites ci-dessus. L'invention est définie par la portée des revendications annexées.

## Revendications

1. Source de plasma (1) destinée au dépôt d'un revêtement sur un substrat (9) et apte à être reliée à une source d'énergie (P) comprenant :
a) Une électrode (2) délimitant une cavité de décharge (3) débouchant sur une ouverture (6) en regard de laquelle ledit substrat peut être positionné, la section transversale de ladite électrode comprenant une première et une deuxième paroi latérale (21, 22) situées de part et d'autre d'un fond (23, 24) muni d'une partie centrale (25) faisant saillie dans ladite cavité de décharge, ladite partie centrale comprenant une première et une deuxième paroi centrale (26, 27) et un sommet (28) reliant les deux parois centrales,
b) un ensemble magnétique (4) situé en périphérie de ladite électrode et comprenant un ensemble d'aimants reliés entre eux par un support magnétique (46), chacun desdits aimants comprenant un pôle exposé tourné vers la cavité de décharge et un pôle protégé orienté vers ledit support magnétique, ledit ensemble d'aimants comprenant :
i. au moins un premier et un deuxième aimant latéral (41,42), ledit premier aimant latéral (41), respectivement deuxième aimant latéral (42), étant disposé derrière ladite première paroi latérale (21), respectivement deuxième paroi latérale (22), à proximité de ladite ouverture (6), lesdits deux aimants latéraux étant orientés de telle façon que leurs pôles exposés soient de même polarité,
ii. au moins un premier et un deuxième aimant central (43, 44), ledit premier aimant central (43), respectivement deuxième aimant central (44), étant disposé derrière ladite première paroi centrale (26), respectivement deuxième paroi centrale (27), lesdits deux aimants centraux étant orientés de telle façon que leur pôle exposé soit de polarité inverse à celle des pôles exposés des aimants latéraux (41,42),
iii. au moins un aimant de tête (45), disposé derrière ledit sommet (28) et orienté de telle façon que son pôle exposé soit de même polarité que celle des pôles exposés des aimants latéraux (41,42),
c) une enceinte électriquement isolante (5) agencée de sorte à entourer l'électrode et les aimants sans boucher ladite ouverture.

2. Source de plasma selon la revendication 1, pour laquelle l'ouverture (6) est de même largeur que la cavité de décharge (3).

3. Sourcede plasma selon l'une quelconque des revendications précédentes, pour laquelle le support magnétique (46) présente la forme d'un E dont la barre du milieu comporte une extrémité élargie de sorte que le pôle protégé de l'aimant de tête (45) soit entièrement en contact avec le support magnétique.

4. Source de plasma selon l'une quelconque des revendications précédentes, pour laquelle le support magnétique (46) est formé d'une seule pièce.

5. Source de plasma selon l'une quelconque des revendications précédentes comprenant en outre un moyen de refroidissement (7) des aimants et de l'électrode.

6. Source de plasma selon la revendication 5, pour laquelle le moyen de refroidissement (7) comprend un espace ménagé entre l'électrode et l'ensemble magnétique et destiné à la circulation d'un fluide caloporteur.

7. Source de plasma selon la revendication 5, pour laquelle le moyen de refroidissement (7) comprend un circuit de tubulures.

8. Source de plasma selon l'une quelconque des revendications précédentes comprenant en outre un moyen d'injection (8) destiné à injecter un gaz ionisable dans la cavité de décharge (3).

9. Source de plasma selon la revendication 8, pour laquelle le moyen d'injection (8) est positionné au voisinage du fond (23, 24).

10. Equipement de dépôt sous vide comprenant une source de plasma selon l'une quelconque des revendications 1 à 9.

11. Equipement de dépôt sous vide selon la revendication 10 comprenant en outre une deuxième source de plasma (1) selon l'une quelconque des revendications 1 à 9, les deux sources de plasma étant destinées à un fonctionnement dual.

12. Equipement de dépôt sous vide selon la revendication 11, pour lequel les axes de symétrie des deux sources de plasma forment un angle α compris entre 20 et 110°.

13. Equipement de dépôt sous vide selon l'une quelconque des revendications 11 ou 12, pour lequel les pôles qui se font face des aimants latéraux (41,42) de la première source de plasma sont de polarité inverse à celle des pôles qui se font face des aimants latéraux (41,42) de la deuxième source de plasma.

14. Equipement de dépôt sous vide selon l'une des revendications 10 à 13 comprenant en outre un injecteur (10) de gaz précurseur.

15. Equipement de dépôt sous vide selon l'une des revendications 10 à 14, comprenant en outre un aimant additionnel (11) positionné en regard de l'ouverture (6) et destiné à se trouver au voisinage du substrat (9) du coté opposé à la source de plasma (1) et de pôle orienté vers la source de plasma (1) de polarité inverse à celle des pôles qui se font face des aimants latéraux (41,42).

## Patentansprüche

1. Plasmaquelle (1), bestimmt zum Aufbringen einer Beschichtung auf ein Substrat (9) und imstande, mit einer Energiequelle (P) verbunden zu sein, umfassend:
a) eine Elektrode (2), die einen Entladungshohlraum (3) begrenzt, der zu einer Öffnung (6) ausmündet, der gegenüber das Substrat positionierbar ist, wobei der Querschnitt der Elektrode eine erste und eine zweite Seitenwand (21, 22) umfasst, die sich beiderseits eines Bodens (23, 24) befinden, der mit einem zentralen Teil (25) ausgestattet ist, der in den Entladungshohlraum hervorsteht, wobei der zentrale Teil eine erste und eine zweite zentrale Wand (26, 27) und eine Spitze (28) umfasst, die die zwei zentralen Wände verbindet,
b) eine magnetische Einheit (4), die sich an der Peripherie der Elektrode befindet und eine Magnetgruppe umfasst, die miteinander mittels einer magnetischen Unterlage (46) verbunden sind, wobei jeder der Magneten einen exponierten Pol umfasst, der in Richtung des Entladungshohlraums zeigt, und einen geschützten Pol, der in Richtung der magnetischen Unterlage zeigt, wobei die Magnetgruppe umfasst:
i. mindestens einen ersten und einen zweiten Seitenmagneten (41,42), wobei der erste Seitenmagnet (41) beziehungsweise zweite Seitenmagnet (42) hinter der ersten Seitenwand (21) beziehungsweise zweiten Seitenwand (22) in der Nähe der Öffnung (6) angeordnet ist, wobei die zwei Seitenmagneten derart ausgerichtet sind, dass ihre exponierten Pole dieselbe Polarität haben,
ii. mindestens einen ersten und einen zweiten zentralen Magneten (43, 44), wobei der erste zentrale Magnet (43) beziehungsweise zweite zentrale Magnet (44) hinter der ersten zentralen Wand (26) beziehungsweise zweiten zentrale Wand (27) angeordnet ist, wobei die zwei zentralen Magneten derart ausgerichtet sind, dass ihr exponierter Pol umgekehrter Polarität zu der der exponierten Pole der Seitenmagneten (41,42) ist,
iii. mindestens einen Kopfmagneten (45), der hinter der Spitze (28) angeordnet ist und derart ausgerichtet ist, dass sein exponierter Pol dieselbe Polarität wie die der exponierten Pole der Seitenmagneten (41,42) hat,
c) einen elektrisch isolierenden Mantel (5), der derart ausgebildet ist, dass er die Elektrode und die Magneten umgibt, ohne die Öffnung zu verschließen.

2. Plasmaquelle nach Anspruch 1, wobei die Öffnung (6) dieselbe Breite wie der Entladungshohlraum (3) hat.

3. Plasmaquelle nach einem der vorangehenden Ansprüche, wobei die magnetische Unterlage (46) die Form eines E aufweist, dessen mittlerer Balken ein erweitertes Ende aufweist, so dass der vom Kopfmagneten (45) geschützte Pol mit der magnetischen Unterlage vollkommen im Kontakt ist.

4. Plasmaquelle nach einem der vorangehenden Ansprüche, wobei die magnetische Unterlage (46) von einem einzigen Teil gebildet ist.

5. Plasmaquelle nach einem der vorangehenden Ansprüche, umfassend ferner ein Kühlmittel (7) der Magneten und der Elektrode.

6. Plasmaquelle nach Anspruch 5, wobei das Kühlmittel (7) einen zwischen der Elektrode und der magnetischen Einheit ausgebildeten Raum umfasst und für die Zirkulation eines Kühlfluids bestimmt ist.

7. Plasmaquelle nach Anspruch 5, wobei das Kühlmittel (7) einen Rohrkreis umfasst.

8. Plasmaquelle nach einem der vorangehenden Ansprüche, umfassend ferner ein Einspritzmittel (8), das bestimmt ist, ein ionisierbares Gas in den Entladungshohlraum (3) zu leiten.

9. Plasmaquelle nach Anspruch 8, wobei das Einspritzmittel (8) in der Nähe des Bodens (23, 24) positioniert ist.

10. Vakuumablagerungsausrüstung, umfassend eine Plasmaquelle nach einen der Ansprüche 1 bis 9.

11. Vakuumablagerungsausrüstung nach Anspruch 10, umfassend ferner eine zweite Plasmaquelle (1) nach einem der Ansprüche 1 bis 9, wobei die zwei Plasmaquellen für eine duale Funktion bestimmt sind.

12. Vakuumablagerungsausrüstung nach Anspruch 11, wobei die Symmetrieachsen der zwei Plasmaquelle einen Winkel zwischen 20 und 110° inklusive bilden.

13. Vakuumablagerungsausrüstung nach einem der Ansprüche 11 oder 12, wobei die Pole, die sich gegenüberstehen, der Seitenmagneten (41,42) der ersten Plasmaquelle umgekehrter Polarität sind zu der der Pole, die sich gegenüberstehen, der Seitenmagneten (41,42) der zweiten Plasmaquelle.

14. Vakuumablagerungsausrüstung nach einem der Ansprüche 10 bis 13, umfassend ferner eine Vorläufergaseinleitung (10).

15. Vakuumablagerungsausrüstung nach einem der Ansprüche 10 bis 14, umfassend ferner einen zusätzlichen Magneten (11), der gegenüber der Öffnung (6) positioniert ist und bestimmt, sich in der Nähe des Substrats (9) auf der zur Plasmaquelle (1) gegenüberliegenden Seite zu befinden und mit einem zur Plasmaquelle (1) zeigenden Pol mit einer umgekehrten Polarität zu der der Pole, die sich gegenüberstehen, der Seitenmagneten (41, 42).

## Claims

1. A plasma source (1) intended for depositing a coating on a substrate (9) and adapted to be connected to a source of energy (P) comprising:
a) an electrode (2) delimiting a discharge cavity (3) opening onto an aperture (6) facing which said substrate may be positioned, the cross-section of said electrode comprising a first and a second side wall (21, 22) located on either side of a bottom (23, 24) having a central portion (25) protruding into said discharge cavity, said central portion comprising a first and a second central wall (26, 27) and a top (28) connecting both central walls,
b) a magnetic set (4) located at the periphery of said electrode and comprising a set of magnets connected together through a magnetic support (46), each of said magnets comprising an exposed pole turned towards the discharge cavity and a protected pole oriented towards said magnetic support, said set of magnets comprising:
i. at least one first and one second side magnet (41,42), said first side magnet (41), respectively second side magnet (42), being positioned behind said first side wall (21), respectively second side wall (22), in proximity to said aperture (6), said both side magnets being oriented in such a way that their exposed poles are of the same polarity,
ii. at least one first and one second central magnet (43, 44), said first central magnet (43), respectively second central magnet (44), being positioned behind said first central wall (26), respectively second central wall (27), said that both central magnets being oriented in such a way that their exposed pole is of reverse polarity to that of the exposed poles of the side magnets (41,42),
iii. at least one head magnet (45), positioned behind said top (28) and oriented in such a way that its exposed pole is of the same polarity as that of the exposed poles of the side magnets (41,42),
c) an electrically insulating chamber (5) laid out so as to surround the electrode and the magnets without blocking said aperture.

2. The plasma source according to claim 1, for which the aperture (6) is of the same width as the discharge cavity (3).

3. The plasma source according to any of the preceding claims, for which the magnetic support (46) has the shape of an E, the middle bar of which includes a widened end so that the protected pole of the head magnet (45) is entirely in contact with the magnetic support.

4. The plasma source according to any of the preceding claims, for which the magnetic support (46) is formed with a single piece.

5. The plasma source according to any of the preceding claims, further comprising a means (7) for cooling the magnets and the electrode.

6. The plasma source according to claim 5, for which the cooling means (7) comprises a space made between the electrode and the magnetic set and intended for the circulation of a heat transfer fluid.

7. The plasma source according to claim 5, for which the cooling means (7) comprises a tubing circuit.

8. The plasma source according to any of the preceding claims, further comprising an injection means (8) intended for injecting an ionizable gas into the discharge cavity (3).

9. The plasma source according to claim 8, for which the injection means (8) is positioned in the vicinity of the bottom (23, 24).

10. A piece of vacuum deposition equipment comprising a plasma source according to any of claims 1 to 9.

11. The piece of vacuum deposition equipment according to claim 10 further comprising a second plasma source (1) according to any of claims 1 to 9, both plasma sources being intended for dual operation.

12. The piece of vacuum deposition equipment according to claim 11, for which the axis of symmetry of both plasma sources form an angle a comprised between 20 and 110°.

13. The piece of vacuum deposition equipment according to any of claims 11 or 12, for which the poles which face each other of the side magnets (41, 42) of the first plasma source are of reverse polarity relatively to that of the poles which face each other of the side magnets (41,42) of the second plasma source.

14. The piece of vacuum deposition equipment according to one of claims 10 to 13 further comprising a precursor gas injector (10).

15. The piece of vacuum deposition equipment according to one of claims 10 to 14 further comprising an additional magnet (11) facing the aperture (6) and intended to be found in the vicinity of the substrate (9) on the opposite side to the plasma source (1) and with a pole oriented towards the plasma source (1) of reverse polarity to that of the poles which face each other of the side magnets (41, 42).
